**Europäisches Patentamt**

**European Patent Office**

**Office européen des brevets**

(19)

(11) Publication number: **0 232 894**
**A2**

(12) **EUROPEAN PATENT APPLICATION**

(21) Application number: **87101800.8**

(22) Date of filing: **10.02.87**

(51) Int. Cl.⁴: **G 03 F 7/00, H 01 L 21/00**

(30) Priority: **13.02.86 IT 4764886**

(43) Date of publication of application: **19.08.87**
**Bulletin 87/34**

(84) Designated Contracting States: **DE FR GB NL SE**

(71) Applicant: **SELENIA INDUSTRIE ELETTRONICHE ASSOCIATE S.p.A., Via Tiburtina, KM 12.400, I-00131 Roma (IT)**

(72) Inventor: **Cetronio, Antonio, via di Villa Taverna 28 Pal. A/3, I-0040 Monteporzio (Roma) (IT)**
Inventor: **Moretti, Sergio, via Polverigi 43, I-00100 Roma (IT)**
Inventor: **Compagnucci, Vittoria, via Lucio Manlio Vulsone 3, I-00175 Roma (IT)**

(74) Representative: **Gustorf, Gerhard, Dipl.-Ing., Mühlenstrasse 1, D-8300 Landshut (DE)**

(54) **Multi layer photopolymeric structure for the manufacturing of MESFET devices with submicrometric gate and variable length recessed channel.**

(57) This invention relates to a technique utilizing conventional photolithography to manufacture GaAs MESFET devices having submicrometric gate and variable length recessed channel. The structure consists of two photopolimeric layers separated by a metal interface. The upper layer, known as a stencil, sets the aperture of the submicrometric gate, while the lower layer, known as the planarizing layer, defines the recessed channel, through the metal interface, which acts as a template. The length of such channel may be varied through suitable choice of exposure time of the planarizing photopolymer. By adopting such multilayer structures it is possible to obtain gate lengths of ~ 5 µm and recessed channel lengths from 0.8 to 3 µm, with a process yield typically better than 90%, simultaneously.

Furthermore, by adopting a thicker planarizing layer, by adopting this structure it is possible to obtain a relatively thick metal deposition (typically of 0.8 µm), such as Ti/Pt/Au overlayer over ohmic contacts and gate pads.

Multi Layer Photopolymeric Structure for the
manufacturing of MESFET devices with submicrometric
gate and variable length recessed channel

Description

With the progress in optical lithography in the submicrometric
region, a number of methods which adopt a two and three layer
photopolymer (1) (5) have been proposed to obtain structures
having sub micron dimensions. Such multi layer systems (MLRs),
in the main, consist of a planarizing layer set on the irregular surface of the slice and of a stencil layer to achieve high
resolution submicrometric structures. Actually these layers are
used to solve the problem of reduced depth of field, inherent
in high resolution optial projection systems.

Although this invention utilizes the concept of planarizing and
stencil layers, it differs from other structures reported to
date in the fact that the two photopolymer layers are separated
by a thin metal film, by virtue of which it is possible to
treat such layers separately, while manufacturing the structure, so that the conditions defining the sub micrometric gate
and the recessed channel are almost identical. As an example,
the stencil layer, which is usually very thin (typically 0,5
µm) requires exposure and development times which differ from
those required by the planarizing layer, which is usually overexposed and which may at times be even thicker (such as ~1,5
µm). The thin metal film consists of a thin Au layer deposited
over an Al layer. The Au layer, which can be readily attacked
through ion milling or r.f. sputtering, is used to achieve a
high definition submicrometric structure (through stencil
resist), while the Al layer is used simply to prevent the
plasma (which appears during Au attack) from damaging or hardening the planarizing layer below. As the gate structure is set
by the Au film, later removal of Al is less critrial and, as such, a simple damp attack may be adopted to unveil the planarization photopolymer. Clearly the exposure time of such photopolymer sets the amount of under-attack which takes place during the development phase, and as such it is possible to take direct control over the MESFET recessed channel length.

This MLR structure is also used for relatively thick metal or non metal film deposition through the lift off technique, as in the case of over layer deposition of Ti/Pt/Au in MESFET devices themselves, which is typically 0,8 $\mu$m thick. As will be discussed and illustrated in the following, for this reason it suffices to vary the thickness of the two photopolimer layers suitably.

The invention will be described in the following with reference to a MLR structure used to manufacture sub micrometric gate and variable length recessed channel MESFETs; this application is reported as an illustration and is not limited to this; in fact a further application of this invention is presented, consisting in an MLR structure for metal or non metal thick film deposition through lift off technique.

Figure 1: Main characteristics of the MLR structure proposed;
Figure 2: (a-h) MLR structure manufacturing phase;
        (i-j) forming of the recessed channel and submicrometric gate deposition;
        (k (i,ii,iii)) different Lg ratios: Lrcs obtainable through the MLR structure;
Figure 3: Diagram of the extent of under attack of the AS planarizing layer as a function of photopolymer exposure time;
Figure 4: MLR structure for: (a) recessed channel gate;
        (b) over layer thick metallization.

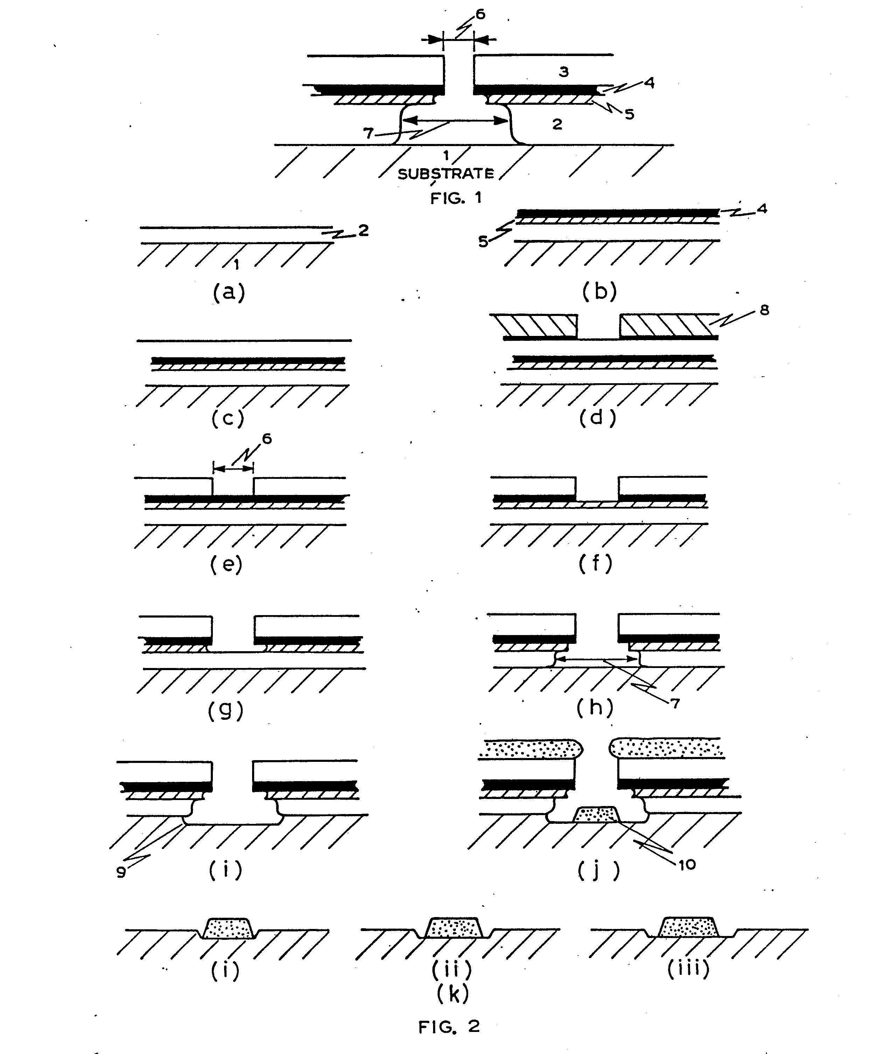

The main characteristics of the MLR structure, outlined using suitable template, are shown in figure 1; this schematic drawing of the invention shows the sub layer 1 (substrate) over which the structure is set, the planarizing photopolymer 2, the stencil photopolymer layer 3, Au thin film 4 and the Al thin film 5. The two main features of such structure, the aperture 6 and the attacked area 7 are formed by appropriately controlling exposure and development of the two photopolymers 2 and 3 in question, and by suitable attack conditions of the two thin metal films 4 and 5.

Details of the different implementation steps required to obtain the MLR structure shown in figure 1 will now be presented with reference to the schematic drawings shown in figure 2.

As shown in figure 2a, the first phase is that of spreading the planarizing photopolymer 2 over sub layer 1 (substrate).

By definition, the planarizing layer ought to be as thick as possible; however for the case in question, i.e. that of submicrometric gate with variable length recessed channel, such layer is preferably thin to ensure that final gate length does not change dimensionally when compared with the aperture length 6, through which it is deposited. For this phase a photopolymer such as AZ1450B by Shipley has been used, which spread at 6000 gpm provides a film ~0,3 $\mu$m thick; then following 90°C baking for 30 minutes of this layer and the next stage is that of depositing the two metal thin films as shown in figure 2b. The Al film 5 and the Au film 4, both about 0,1 $\mu$m thick, are deposited in ultra high vacuum conditions to ensure good film quality and in particular good adherence between Al film and the planarizing photopolymer. As shown in figure 2c, the final phase of MLR structure preparation is to spread over the existing layers, the stencil photopolymer 3 and then to subject the entire structure to further baking at 90°C for 30 minutes. By definition, the stencil layer should be as thin as possible to ensure best resolution during template reproduction over the same layer; in fact also in this case, as an example, photopolymer AZ1450B by Shipley has been used, which at a $\sim$ 2000 gpm spread provides a 0,5 $\mu$m layer.

The main steps required to outline the MLR structure shown in figure 1 (i.e. with aperture 6 for the submicrometric gate and sub attack 7 for the recessed channel) are the following:

a) exposure of the stencil layer through a template 8 (figure 2d) and following development to define aperture 6 of the submicrometric gate as shown in figure 2e;

b) using the stencil layer as a template, attack the Au film through ion milling or r.f. sputtering (figure 2f). The attack conditions should damage the stencil layer to the least extent possible and should avoid Au redeposition on the sides of the photopolymer itself; erosion in low pressure plasma (typically Ar at $1 \times 10^{-4}$ torr) satisfies such conditions. As selectivity between Au and Al attack speeds is very high using Ar, the end point detection of Au attack is not too critical, and as such the process duration is set by the time required to harden the photopolymer stencil layer through the plasma radiation, to an extent that it becomes insensitive to further light exposures.

c) With the stencil layer and the Au film as template, the Al film is attacked by a solution of 30% $H_3PO_4$ in deionized water at 50° C. As the gate aperture is defined by the Au film, this phase is not too critical and as shown in figure 2g, a limited amount of under attack is normally accepted.

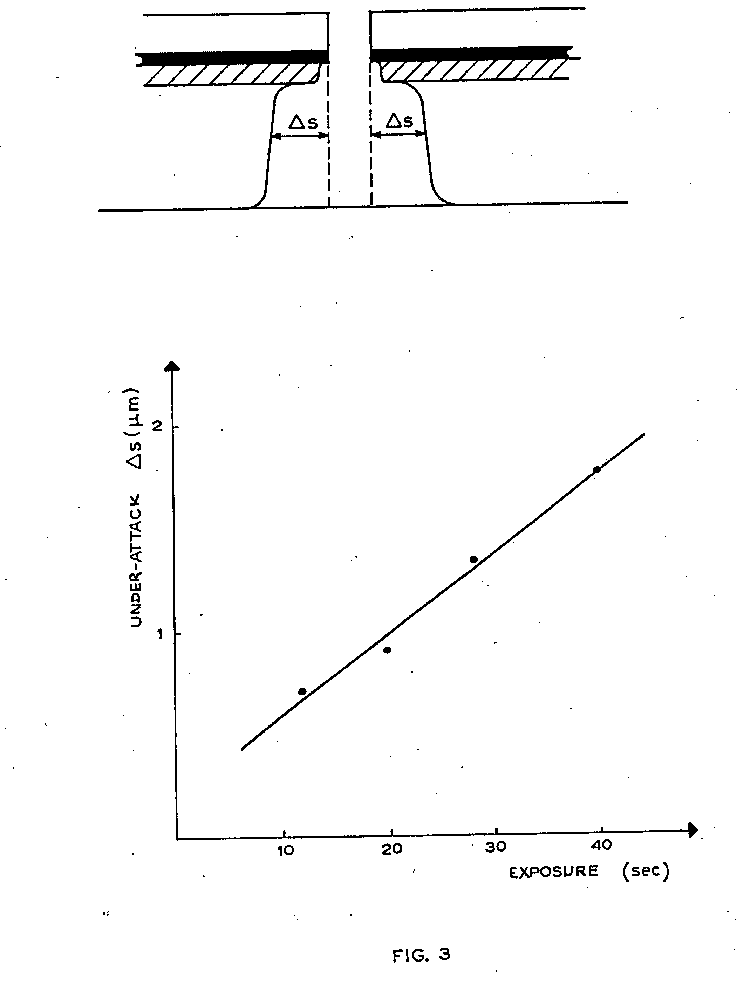

d) With the stencil layer and the Au film as template, the planarizing layer is exposed and developed to achieve a final structure as shown in figure 2h. As shown in figure 3, the extent of under attack of planarizing layer $\Delta$s, within limits, is almost proportional to the photopolymer exposure time. As the length of the recessed channel $L_{rc} = L_g + 2\Delta s$, such dimension 7 may be varied easily through predetermined exposures of the photopolymer.

As shown in figure 2h, hardening by radiation of the stencil layer has saved it from possible damage due to the exposure and development of the planarizing layer.

e) With the whole MLR structure as template, the recessed channel 9 (figure 2i) is cut in the GaAs substrate through suitable wet attack (such as $H_2O_2 + NH_4OH + H_2O$).

f) Using the whole MLR structure as template, gate 10 is deposited through evaporation or sputtering as shown in figure 2j.

g) Removal of the whole MLR structure through lift·off within acetone leaves the submicrometric gate and the recessed channel on the GaAs substrate as expected. Figures 2k (i, ii, iii) show different configurations of $Lg/L_{rc}$; in fact case (i) is more suitable for low noise MESFETs, while case (iii) is best suited for power devices.

This invention pertains to a technique which adopts conventional photolithography to obtain submicrometric gate and variable length recessed channel MESFET devices. Such technique adopts an MLR structure with two layers of photopolymer separated by a very thin metal interface. The upper fotopolymer, called stencil layer, is used to define the submicrometric gate, while the one in contact with the substrate, called planarizing layer, is used to define the length of the recessed channel. The length of the latter can be set and varied accurately through suitable selection of planarizing layer exposure times.

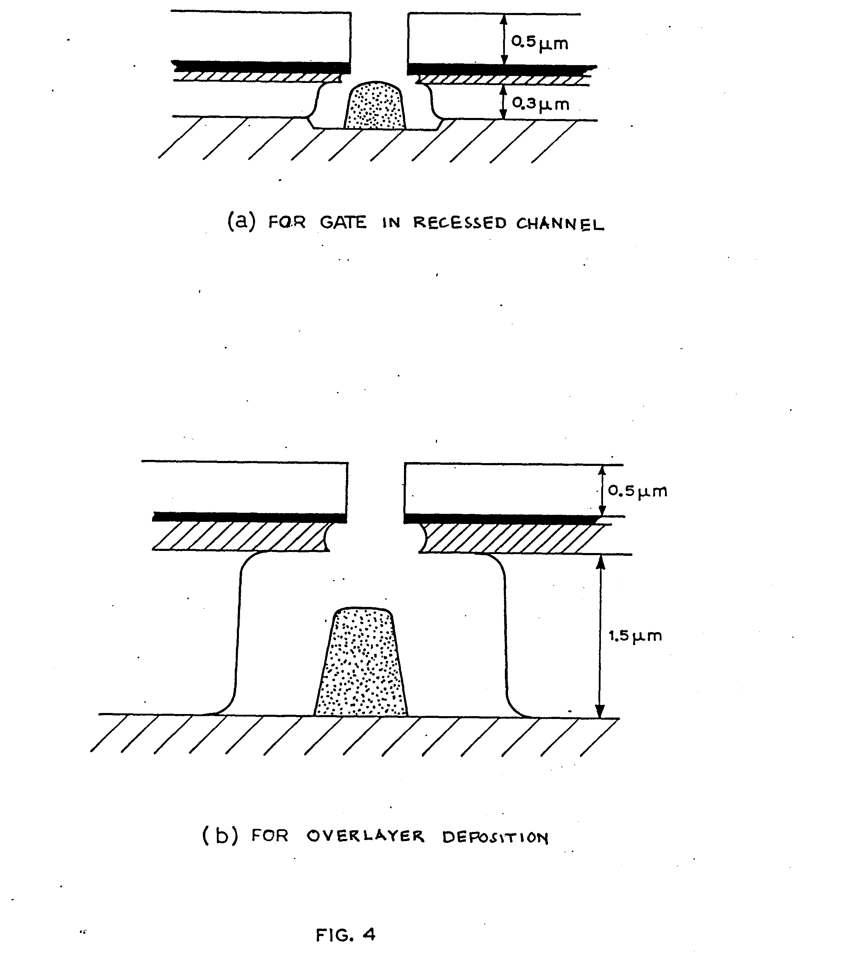

Through such multilayer structure (figure 4a) a gate length of ~ 0,5 μm and channel length between ~ 0,8 to 3 μm can be obtained simultaneously. Furthermore, through a thicker planarization layer (figure 4b) the same structure can be used to deposit relatively thick metal films (typically 0,8 μm) adopting the lift off technique, such as over layer deposition of Ti/Pt/Au over the MESFET ohmic contacts.

## References

1. K. Tsuji, M. Lasago and K. Kugimiya, IEEE Trans. on Electron Devices, ED 31 (1984) 1861.

2. J.M. Morgan and D. Maydan, J. Vac. Sci. Tech. 16 (1979) 1620.

3. M.M.O. Toole, E.D. Liu and M.S. Chang, Proc. SPIE, 275 (1981) 128.

4. B.J. Lin, Proc. SPIE, 174 (1979) 114.

5. K. Tsuji, M. Lasago and K. Kugimiya, 1983 VLSI Symp. VLSI Tech. Dig. Tech. Papers (1983) 78.

## Claims

1. Multilayer photopolymeric structure for the manufacturing of MESFET devices, consisting of a submicrometric gate and a variable length recessed channel, characterized by the adoption of a MLR (multi layer resist) structure with two photopolymer layers (2,3) separated by a thin metal interface (4,5).

2. Multilayer photopolimeric structure as claimed in claim 1, wherein the upper photopolimeric layer is used to define the aperture of the submicrometric gate (6) and simultaneously the planarizing layer (2) in contact with substrate (1), is used to define the length of the recessed channel (7).

3. Photopolymer structure as claimed in claim 1 or 2, wherein by varying the exposure time of the planarizing layer the length of the recessed channel may be varied (Fig. 3).

4. Photopolimeric structure as claimed in claims 1 and 2, wherein a gate to recessed channel length ratio equal to 1 provides a low noise MESFET (Figure 2 k,i)

5. Photopolymeric structure as claimed in claims 1 and 2, wherein a gate to recessed channel length ratio > 1 provides a power MESFET (Figure 2 k,iii).

6. Photopolymeric structure as claimed in claims 1 and 2 in which the structure consists of a thicker planarizing layer (Fig. 4b), wherein the same structure may be used to deposit metal films, which are relatively thick, through the lift off technique; as in the case of over layer deposition of Ti/Pt/Au or other element over the MESFET ohmic contacts.

FIG. 1

(a)

(b)

(c)

(d)

(e)

(f)

(g)

(h)

(i)

(j)

(i)   (ii)   (iii)

(k)

FIG. 2

FIG. 3

0232894

0.5 μm

0.3 μm

(a) FOR GATE IN RECESSED CHANNEL

0.5 μm

1.5 μm

(b) FOR OVERLAYER DEPOSITION

FIG. 4